# EUROPEAN PATENT SPECIFICATION

(11) **EP 4 358 259 B1**
(45) Date of publication and mention of the grant of the patent: **09.12.2026**
(21) Application number: 22909727.4
(22) Date of filing: 06.12.2022
(51) Int. Cl.: H01M 50/244, H01M 50/251, H01M 10/613, H01M 10/42, H01M 10/625, H01M 10/627, H01M 10/6556, H01M 10/6563, H01M 10/6566, H01M 50/204, H01M 50/209, H01M 50/249, H05K 7/20

(54) **ENERGY STORAGE EQUIPMENT**
ENERGIESPEICHERAUSRÜSTUNG
ÉQUIPEMENT DE STOCKAGE D'ÉNERGIE

(30) Priority: 22.12.2021 CN 202123248346 U
(43) Date of publication of application: 24.04.2024
(73) Proprietor: Contemporary Amperex Technology (Hong Kong) Limited, Central, Hong Kong (HK)
(72) Inventor: ZHENG, Chenling, Ningde City, Fujian 352100 (CN); LIU, Yue, Ningde City, Fujian 352100 (CN); WANG, Peng, Ningde City, Fujian 352100 (CN); WANG, Zengzhong, Ningde City, Fujian 352100 (CN)
(74) Representative: Gong, Jinping
(86) International application number: PCT/CN2022/136822
(87) International publication number: WO 2023/116412

(56) References cited:
- CN-A- 109 509 937
- CN-A- 109 768 348
- CN-U- 206 976 530
- CN-U- 209 814 816
- CN-U- 212 289 823
- CN-U- 216 720 160
- JP-A- 2015 191 717

## Description

### TECHNICAL FIELD

This application relates to the technical field of battery production, and in particular, to an energy storage device as specified in any of claims 1-11.

### BACKGROUND

An energy storage device is an electric energy storage and transfer device in which a plurality of battery cells are placed. The energy storage device is characterized by convenient mounting and transportation, high degree of integration, a small footprint, and high scalability, and is an important part of an energy storage system for the development of distributed energy, smart grid, and energy Internet.

The higher the number of battery cells in the energy storage device, the higher the energy density of the energy storage device. How to improve an overall energy density of the energy storage device is an urgent problem to be solved.

CN 209 814 816 U discloses an energy storage device comprising: a battery box with a first box body and a plurality of battery cells accommodated therein, an electrical box arranged alongside the battery box and comprising an electrical assembly disposed therein and electrically connected to the battery cells to exercise electrical control on the battery box; and an air duct assembly located between the first box body and the second box body to separate them and separately in communication with them.

### SUMMARY

The present invention is defined by the appended claims. This application provides an energy storage device to increase an energy density of the energy storage device.

The energy storage device disclosed herein includes a battery box, an electrical box, and an air duct assembly. The battery box includes a first box body, a plurality of battery cells, and a thermal management assembly. The plurality of battery cells and the thermal management assembly are accommodated in the first box body. The thermal management assembly is configured to provide a heat transfer gas. The electrical box is arranged alongside the battery box. The electrical box includes a second box body and an electrical assembly disposed in the second box body. The electrical assembly is electrically connected to the battery cells to exercise electrical control on the battery box. In the air duct assembly, at least a part of the air duct assembly is located between the first box body and the second box body to separate the first box body from the second box body, and the air duct assembly serves as an air partition to separate the first box body from the second box body. The air duct assembly is in communication with the first box body and the second box body respectively so that the heat transfer gas provided by the thermal management assembly exchanges heat with the electrical box through the air duct assembly.

**In** the above technical solution, the battery box and the electrical box are arranged side by side, thereby vacating an internal space of the battery box and increasing an effective available space in the battery box. In this way, a sufficient space is available for placing the battery cells, thereby increasing the number of battery cells that can be accommodated, and increasing the energy density of the energy storage device. Heat is generated during the operation of the electrical box. The heat in the electrical box is conducted toward the battery box. An air duct assembly is disposed between the battery box and the electrical box. The heat transfer gas exchanges heat for the electrical box through the air duct assembly, thereby removing the heat in the electrical box in time, cooling the electrical box effectively, reducing the risk of thermal runaway of the electrical box, and further improving safety performance of the energy storage device.

**In** some embodiments, the first box body includes a first chamber and a second chamber arranged side by side along a first direction. The first chamber is configured to accommodate the plurality of battery cells, and the second chamber is configured to accommodate the thermal management assembly. The second box body is located on a side of the first chamber, the side being oriented back from the second chamber. The air duct assembly includes a first duct and a second duct. The first duct is located between the first chamber and the second box body to separate the first box body from the second box body. The second duct is disposed in the first box body and communicates the first duct and the second chamber. In these embodiments of this application, the first chamber is located near the second box body, thereby facilitating electrical connection between the electrical assembly and the battery cells, and facilitating the control exercised on the battery cells by the electrical assembly.

In some embodiments, the first duct includes an opening oriented toward a second direction so that the heat transfer gas flows to an external environment through the opening along the second direction, and the second direction is parallel to an extension direction of the first duct and perpendicular to the first direction. In these embodiments of this application, the first duct is an open structure. The heat transfer gas flows out directly through the opening, thereby driving the air in the second box body to flow out of the opening to the external environment. This structure facilitates quick removal of the heat in the second box body, reduces complexity of the device, and avoids the need to dispose an additional gas collection device.

In some embodiments, the first duct, a wall of the first chamber, and the second box body close in to form a first flow channel, and the first flow channel is configured to provide a channel through which the heat transfer gas flows. The structural form of so structured first duct is relatively simple, thereby reducing the overall weight and cost of the device.

In some embodiments, the first duct includes: a plurality of supporting pieces extending along a second direction, where the plurality of the supporting pieces are spaced apart along a third direction and form an opening between the plurality of supporting pieces, and the opening is oriented toward the second direction, and the third direction, the second direction, and the first direction are perpendicular to each other; and a connecting piece extending along the third direction. The connecting piece is configured to guide an airflow in the second duct to the opening. In these embodiments of this application, the first duct is a framework structure formed by splicing the connecting piece and the plurality of supporting pieces. The structural form of the first duct is simple, thereby reducing the overall weight and cost of the device.

In some embodiments, the air duct assembly includes an air guiding member. The air guiding member is configured to drive the heat transfer gas to flow from the second duct toward the first duct. In these embodiments of this application, the air guiding member guides the heat transfer gas to flow, thereby improving the heat transfer efficiency between the heat transfer gas and the gas in the second box body.

In some embodiments, the first duct intersects the second duct. The air guiding member is disposed at least at a junction between the first duct and the second duct. In these embodiments of this application, the air guiding member can guide, at the junction, the heat transfer gas to flow to the first duct, and reduce the risk of eddy flow and reflux to some extent, thereby improving the heat transfer efficiency between the heat transfer gas and the gas in the second box body.

In some embodiments, the air guiding member includes a first guide piece and a second guide piece. The first guide piece is disposed at the junction between the first duct and the second duct to drive the heat transfer gas to flow from the second duct toward the first duct. The second guide piece is disposed inside the first duct to drive the heat transfer gas to flow in the first duct along a second direction, and the second direction is parallel to an extension direction of the first duct and perpendicular to the first direction. In these embodiments of this application, the synergistic effect of the first guide piece and the second guide piece can significantly increase the air speed and air volume of the heat transfer gas flowing into the second duct, thereby improving the heat transfer efficiency between the heat transfer gas and the gas in the second box body, taking away the heat in the second box in time, and improving the overall safety performance of the energy storage device.

In some embodiments, the second chamber includes a plurality of air outlets in communication with the thermal management assembly. The second duct includes a plurality of second flow channels communicating with the plurality of air outlets respectively. Each of the plurality of second flow channels is configured to provide a channel through which the heat transfer gas flows, so as to regulate flow uniformity of the heat transfer gas. In these embodiments of this application, a plurality of air outlets are disposed on the second chamber, so that the heat transfer gas flows out after being split into a plurality of airflows, thereby improving the flow uniformity of the heat transfer gas. In addition, the air speed at each air outlet is relatively high, thereby increasing the flow speed of the air flowing into the first duct, and in turn, improving the heat transfer efficiency between the heat transfer gas and the gas in the second box body.

In some embodiments, the energy storage device further includes a fixing piece. The fixing piece is fixedly connected to the first box body and the second box body and is configured to clamp at least a part of the air duct assembly between the first box body and the second box body. In these embodiments of this application, the fixing piece fixedly connects the first box body and the second box body together, thereby improving the structural stability of the energy storage device.

In some embodiments, container comer fittings are disposed on both the first box body and the second box body. The container comer fittings can carry the weight of the first box body and the second box body, and, during transportation, can be latched to the transportation equipment, thereby reducing the risk of damage to the energy storage device.

### BRIEF DESCRIPTION OF DRAWINGS

To describe the technical solutions of some embodiments of this application more clearly, the following outlines the drawings used in the embodiments of this application. Evidently, the drawings outlined below are merely a part of embodiments of this application. A person of ordinary skill in the art may derive other drawings from the outlined drawings without making any creative efforts.
FIG. 1 is a schematic structural diagram of an energy storage device according to some embodiments of this application;
FIG. 2 is a schematic structural diagram of a battery according to some embodiments of this application;
FIG. 3 is a schematic exploded view of an energy storage device according to some embodiments of this application;
FIG. 4 is a schematic structural diagram of an air duct assembly of an energy storage device according to some embodiments of this application;
FIG. 5 is a schematic structural diagram of an energy storage device according to some other embodiments of this application; and
FIG. 6 is a schematic exploded view of an energy storage device according to some other embodiments of this application.

The drawings are not necessarily drawn to scale.

List of reference numerals:
X. first direction; Y. second direction; Z. third direction;
1000. energy storage device;
100. battery box; 110. first box body; 111. first chamber; 1111. wall; 112. second chamber; 1121. air outlet;
120. thermal management assembly;
130. battery; 131. battery cell;
200. electrical box; 210. second box body; 211. electrical assembly;
300. air duct assembly;
310. first duct; 311. opening. 312. first flow channel; 313. supporting piece; 314. connecting piece;
320. second duct; 321. second flow channel;
330. air guiding member; 331. first guide piece; 332. second guide piece;
400. fixing piece;
500. container comer fitting.

### DETAILED DESCRIPTION OF EMBODIMENTS

To make the objectives, technical solutions, and advantages of the embodiments of this application clearer, the following gives a clear description of the technical solutions in the embodiments of this application with reference to the drawings in the embodiments of this application. Evidently, the described embodiments are merely a part of but not all of the embodiments of this application.

Unless otherwise defined, all technical and scientific terms used herein have the same meanings as what is normally understood by a person skilled in the technical field of this application. The terms used in the specification of this application are merely intended to describe specific embodiments. The terms "include" and "contain" and any variations thereof used in the specification, claims, and brief description of drawings of this application are intended as non-exclusive inclusion. The terms such as "first" and "second" used in the specification, claims, and brief description of drawings herein are intended to distinguish between different items, but are not intended to describe a specific sequence or order of precedence.

Reference to "embodiment" in this application means that a specific feature, structure or characteristic described with reference to the embodiment may be included in at least one embodiment of this application. Reference to this term in different places in the specification does not necessarily represent the same embodiment, nor does it represent an independent or alternative embodiment in a mutually exclusive relationship with other embodiments.

In the description of this application, unless otherwise expressly specified and defined, the terms "mount", "concatenate", "connect", and "attach" are understood in a broad sense. For example, a "connection" may be a fixed connection, a detachable connection, or an integrated connection; or may be a direct connection or an indirect connection implemented through an intermediary; or may be internal communication between two components. A person of ordinary skill in the art is able to understand the specific meanings of the terms in this application according to specific situations.

The term "and/or" in this application indicates merely a relation for describing the related items, and represents three possible relationships. For example, "A and/or B" may represent the following three circumstances: A alone, both A and B, and B alone. In addition, the character "/" herein generally indicates an "or" relationship between the item preceding the character and the item following the character.

In embodiments of this application, the same reference numeral denotes the same component. For brevity, detailed descriptions of the same component are omitted in a different embodiment. Understandably, dimensions such as thickness, length, and width of various components in the embodiments of this application shown in the drawings, and dimensions such as overall thickness, length, and width of an integrated device are merely illustrative descriptions, but do not constitute any limitation on this application.

"A plurality of" referred to in this application means two or more (including two).

In this application, a battery cell may be a lithium-ion secondary battery cell, a lithium-ion primary battery cell, a lithium-sulfur battery cell, a lithium-sodium-ion battery cell, a sodium-ion battery cell, a magnesium-ion battery cell, or the like. The type of the battery cell is not limited herein. The battery cell may be in various shapes such as cylindrical, flat, cuboidal or other shapes. The embodiments of this application do not limit the shape of the battery cell. Depending on the form of packaging, the battery cell is typically classed into three types: cylindrical battery cell, prismatic battery cell, and pouch-type battery cell, without being limited in embodiments of this application.

An energy storage device is a device that integrates an electrical assembly and a plurality of battery cells in a container. The electrical assembly is coupled to the plurality of battery cells to manage the plurality of battery cells. The battery cells may serve as a backup power supply, or serve a peak load shaving purpose in a case that the power system provides power unevenly, or perform frequency regulation when the load or output of the power system is relatively high, or may be applied in a photovoltaic-battery energy storage system.

The operating temperature range of a battery cell is relatively narrow, and is 10 °C to 40 °C. The operating temperature range of an electrical assembly is relatively wide, and may be as wide as -20 °C to 65 °C. During operation, the electrical assembly generates a large amount of heat, and is at risk of thermal runaway. In a case of thermal runaway, the temperature of the electrical assembly rises sharply. When the heat generated by the electrical assembly is conducted to the battery cell, the temperature of the battery cell may exceed the operating temperature of the battery cell, thereby giving rise to thermal runaway of the battery cell. To reduce the effect of the heat generated by the electrical assembly on the battery cell, a heat-insulating bulkhead is disposed between the electrical assembly and the battery cell. The bulkhead is configured to separate the electrical assembly from the battery cell.

The energy storage device needs to meet international standards set forth by the International Organization for Standardization (ISO). The energy storage device is subject to weight and size limitations. Therefore, the number of battery cells that can be accommodated is restricted.

The inventor finds that the arrangement of the bulkhead reduces the accommodation space of the battery box. In addition, the bulkhead is of a specified weight, thereby further reducing the effective available space of the energy storage device and reducing the number of battery cells that can be disposed, and in turn, reducing the energy density of the energy storage device.

Based on the foregoing problems detected by the applicant hereof, the applicant has improved the structure of the energy storage device. Some embodiments of this application are described below in more detail.

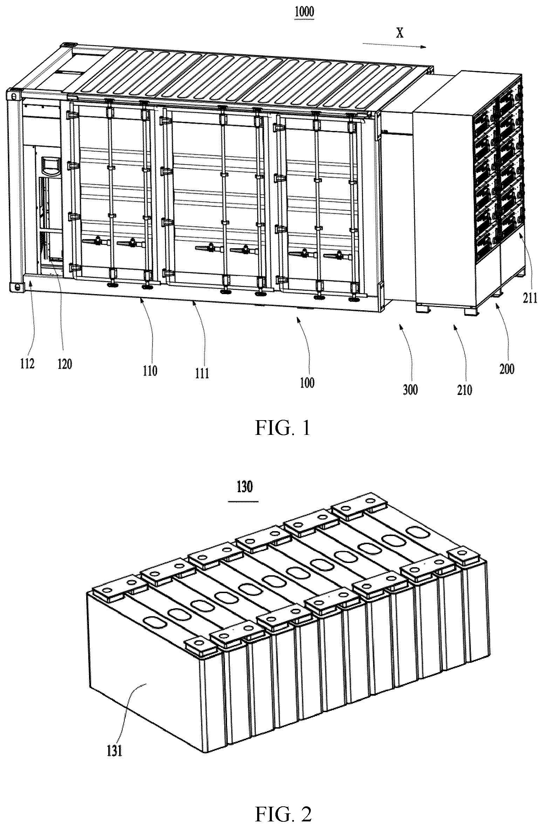

For a better understanding of this application, the following describes some embodiments of this application with reference to FIG. 1 to FIG. 6.

FIG. 1 is a schematic structural diagram of an energy storage device according to some embodiments of this application, and FIG. 2 is a schematic structural diagram of a battery according to some embodiments of this application.

As shown in FIG. 1 and FIG. 2, the energy storage device 1000 provided in an embodiment of this application includes a battery box 100, an electrical box 200, and an air duct assembly 300.

The battery box 100 includes a first box body 110, a plurality of battery cells 131, and a thermal management assembly 120. The plurality of battery cells 131 and the thermal management assembly 120 are accommodated in the first box body 110. The thermal management assembly 120 is configured to provide a heat transfer gas.

To meet transportation requirements, the shape of the first box body 110 as an accommodation device may be a cuboid that matches specified dimensions of the transportation standard. The accommodation space of the cuboidal box is relatively large, thereby increasing the accommodation space of the first box body 110 for accommodating the battery cells 131. The first box body 110 may be assembled from metal members or from other materials such as organic polymers.

A plurality of battery cells 131 are connected in series, parallel, or series-and-parallel pattern to form a battery 130. The battery 130 may be a battery pack or a battery module to provide a higher voltage and a higher capacity for the energy storage device 1000.

After being powered up, the thermal management assembly 120 can detect parameters such as temperature of the electrical box 200 in real time. When it is detected that the temperature of the electrical box 200 rises and reaches a threshold, the thermal management system 120 can provide a heat transfer gas to cool down the electrical box 200, so as to ensure steady operation of the electrical box 200. The thermal management system 120 can also adaptively adjust the air speed of the heat transfer gas based on the detected temperature of the electrical box 200, so as to exchange heat of the electrical box 200 rapidly. As an example, the thermal management system 120 includes a fan. The fan can deliver a heat transfer gas into an air duct assembly 300 to cool down the electrical box 200. The heat transfer gas may be a refrigerant gas or air, and is not limited herein.

The electrical box 200 is arranged alongside the battery box 100. As an example, the electrical box 200 and the battery box 100 are arranged sequentially along a first direction X. The X-direction shown in FIG. 1 represents the first direction. The first direction X may be parallel to a length direction of the battery box 100.

The electrical box 200 includes a second box body 210 and an electrical assembly 211 disposed in the second box body 210. The electrical assembly 211 is electrically connected to the battery cells 131, and can manage the battery cells 131. For example, the electrical assembly 211 includes a power conversion system (Power Conversion System, PCS). The PCS can control a charging process and a discharging process of the battery cell 131, perform transformation between alternating current and direct current, and the like.

An air duct through which the heat transfer gas flows can be formed in the air duct assembly 300. At least air ducts of the air duct assembly 300 are located between the first box body 110 and the second box body 210. The air duct assembly 300 serves as an air partition to separate the first box body 110 from the second box body 210. For purposes herein, the term "at least air ducts" means at least a part of the air duct assembly 300. The air duct assembly 300 is in communication with the first box body 110 and the second box body 210 separately so that the heat transfer gas provided by the thermal management assembly 120 can exchange heat with the electrical box 200 through the air duct assembly 300. The air duct assembly 300 is in communication with the first box body 110, so that the heat transfer gas provided by the thermal management assembly 120 can flow to the air duct assembly 300 and, through the air duct assembly 300, flow to the second box body 210.

In this embodiment of this application, the battery box 100 and the electrical box 200 are arranged side by side, thereby vacating the internal space of the battery box 100 and increasing the effective available space in the battery box 100. In this way, a sufficient space is available for placing the battery cells 131, thereby increasing the number of battery cells 131 that can be accommodated, and increasing the energy density of the energy storage device 1000.

Heat is generated during the operation of the electrical box 200. The heat in the electrical box 200 is conducted toward the battery box 100. An air duct assembly 300 is disposed between the battery box 100 and the electrical box 200. In other words, the battery box 100 and the electrical box 200 are spaced apart. This arrangement can slow down the heat conduction from the electrical box 200 to the battery box 100, thereby reducing the risk of thermal runaway of the battery box 100, and improving the safety performance of the energy storage device 1000. At least air ducts of the air duct assembly 300 are located between the first box body 110 and the second box body 210. The heat transfer gas exchanges heat for the electrical box 200 through the air duct assembly 300, thereby removing the heat in the electrical box 200 in time, cooling the electrical box 200 effectively, reducing the risk of thermal runaway of the electrical box 200, and further improving safety performance of the energy storage device 1000.

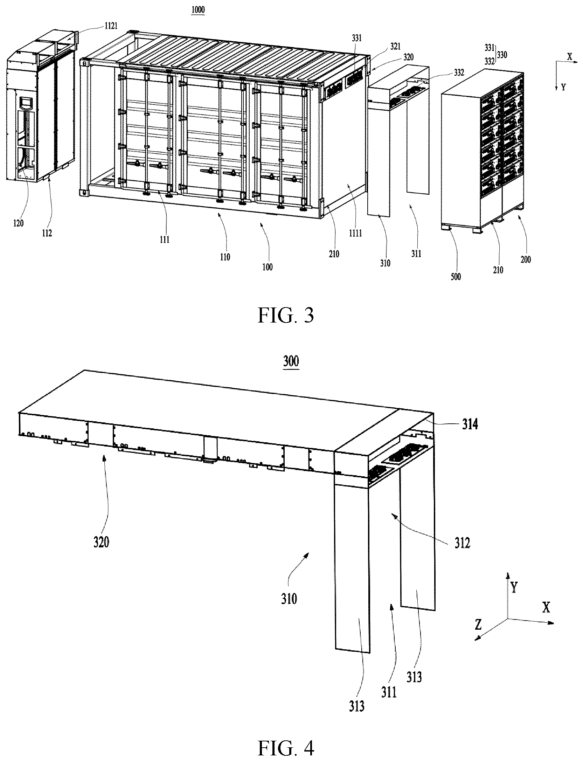

FIG. 3 is a schematic exploded view of an energy storage device according to some embodiments of this application.

As shown in FIG. 3, the first box body 110 includes a first chamber 111 and a second chamber 112 arranged side by side along a first direction X. The first chamber 111 is configured to accommodate a plurality of battery cells, and the second chamber 112 is configured to accommodate the thermal management assembly 120. The second box body 210 is located on a side of the first chamber 111, the side being oriented back from the second chamber 112. The air duct assembly 300 includes a first duct 310 and a second duct 320. The first duct 310 is located between the first chamber 111 and the second box body 210 to separate the first box body 110 from the second box body 210. The second duct 320 is disposed in the first box body 110 and communicates the first duct 310 and the second chamber 112. The first chamber 111 is located near the second box body 210, thereby facilitating electrical connection between the electrical assembly 211 and the battery cells, and facilitating the control exercised on the battery cells by the electrical assembly 211.

Alternatively, the second box body 210 is disposed on a side of the second chamber 112, the side being oriented back from the first chamber 111. In this way, the thermal management assembly 120 located in the second chamber 112 is at a smaller distance from the second box body 210, and the air duct of the air duct assembly 300 is relatively short. When detecting that the temperature in the electrical box 200 reaches a threshold, the thermal management assembly 120 can perform heat exchange for the electrical box 200 in time.

When the heat transfer gas in the first duct 310 flows, on the one hand, the heat transfer gas can exchange heat with the air in the second box body 210 to reduce the temperature in the second box body 210. On the other hand, the heat transfer gas can drive the air in the second box body 210 to flow back from the second box body 210, thereby removing some heat in the second box body 210.

In some embodiments, the first duct 310 includes an opening 311 oriented toward a second direction Y so that the heat transfer gas flows to an external environment through the opening 311 along the second direction Y. The first duct 310 is an open structure. The heat transfer gas flows out directly through the opening 311, thereby driving the air in the second box body 210 to flow out of the opening 311 to the external environment. This structure facilitates quick removal of the heat in the second box body 210, reduces complexity of the device, and avoids the need to dispose an additional gas collection device. The Y-direction shown in FIG. 3 represents the second direction Y. The second direction Y is parallel to the extension direction of the first duct 310 and perpendicular to the first direction X. The extension direction of the first duct 310 may be parallel to a height direction of the battery box 100.

Alternatively, the first duct 310 may be a closed structure, and the first duct 310 is configured to communicate with an external gas collection device to collect gas. Especially, when the heat transfer gas is a refrigerant gas, the gas collection device collects the refrigerant gas, so as to facilitate recycling and reduce cost.

Still referring to FIG. 3, in some embodiments, the first duct 310, a wall 1111 of the first chamber 111, and the second box body 210 close in to form a first flow channel 312. The first flow channel 312 is configured to provide a channel through which the heat transfer gas flows. The first duct 310 is an open structure. By utilizing the structures of the battery box 100 and the electrical box 200, a channel available for the flow of gas is formed. The structural form of so structured first duct 310 is relatively simple, thereby reducing the overall weight and cost of the device.

FIG. 4 is a schematic structural diagram of an air duct assembly of an energy storage device according to some embodiments of this application.

As shown in FIG. 3 and FIG. 4, as some examples, the first duct 310 includes a connecting piece 314 and a plurality of supporting pieces 313. The plurality of supporting pieces 313 extend along the second direction Y, and are spaced apart along a third direction Z. An opening 311 oriented toward the second direction Y is formed between the plurality of supporting pieces 313. The connecting piece 314 extends along the third direction Z. The connecting piece 314 is configured to guide the heat transfer gas of the second duct 320 to the opening 311. All end portions of the plurality of supporting pieces 313 along the second direction Y are connected to the connecting piece 314, so that the connecting piece 314, the plurality of supporting pieces 313, the wall of the first chamber 111, and the second box body close in to form a first flow channel 312. The first duct 310 is a framework structure formed by splicing the connecting piece 314 and the plurality of supporting pieces 313. The structural form of the first duct is simple, thereby reducing the overall weight and cost of the device.

In FIG. 4, the Z-direction represents the third direction. The third direction Z, the second direction Y, and the first direction X are perpendicular to each other. The third direction Z may be parallel to the width direction of the battery box.

As an example, the number of supporting pieces 313 is two. An opening 311 oriented toward the second direction Y is formed between the two supporting pieces 313. The two supporting pieces 313 and the connecting piece 314 are spliced together to form the first duct 310, thereby further simplifying the structure of the first duct 310. Alternatively, the number of supporting pieces 313 is three. An opening 311 oriented toward the second direction Y is formed between the three supporting pieces 313. The three supporting pieces 313 bisect the opening 311. Correspondingly, the first flow channel 312 is divided into two flow channels, thereby improving uniformity of the flow of the heat transfer gas in the first duct 310, improving consistency of the heat transfer effect of the heat transfer gas everywhere in the second box body, and improving the heat transfer efficiency. Alternatively, the number of supporting pieces 313 may be set to four, five, and so on, and the specific number of supporting pieces 313 is not limited herein.

The second duct 320 is an intermediate medium that communicates the first duct 310 and the second chamber. The second duct 320 may be designed as a hollow duct, such as a rectangular duct or a duct of another shape. The duct may be formed by splicing a plurality of plates together.

Still referring to FIG. 3 and FIG. 4, in some embodiments, the second duct 320 may be disposed in the first box body 110. As an example, the first box body 110 includes a battery rack. The battery cells are disposed on the battery rack, and the second duct 320 is disposed above the battery cells. When the battery cells are assembled in the first box body 110, the second duct 320 can be assembled in the first box body 110 at the same time, thereby facilitating the overall assembling of the energy storage device 1000.

The operating temperature range of the electrical assembly 211 is relatively wide. To cool down the electrical box 200, the temperature of the heat transfer gas in the second duct 320 may be relatively low. The temperature of the heat transfer gas may be lower than the operating temperature of the battery cells. If the distance between the heat transfer gas and the battery cells is relatively short, heat exchange may occur between the heat transfer gas and the battery cells. Consequently, the temperature of the battery cells may decrease to a value lower than the operating temperature of the battery cells, and make the battery cells unable to operate normally.

To reduce the adverse effect caused by the heat transfer gas onto the battery cells, in some other embodiments, the second duct 320 may be disposed outside the first box body 110, thereby effectively alleviating the adverse effect of the second duct 320 on the battery cells in the first box body 110.

If the length of the air duct assembly 300 is relatively large, the air resistance in the air duct assembly 300 is relatively high. In a process of conveying the heat transfer gas, the air speed of the heat transfer gas arriving at the electrical box 200 is reduced, thereby reducing the heat transfer efficiency between the heat transfer gas and the gas in the second box body 210.

Still referring to FIG. 3 and FIG. 4, in order to improve the heat transfer efficiency between the heat transfer gas and the gas in the second box body 210, in some embodiments, the air duct assembly 300 further includes an air guiding member 330. The air guiding member 330 is configured to drive the heat transfer gas to flow from the second duct 320 toward the first duct 310. The air guiding member 330 guides the heat transfer gas to flow, thereby improving the heat transfer efficiency between the heat transfer gas and the gas in the second box body 210. As an example, the air guiding member 330 includes a fan, and the diversion effect of the fan increases the air speed of the heat transfer gas. Alternatively, the air guiding member 330 may include a third guide piece and a through-hole created on the third guide piece. The third guiding member is connected inside the air duct assembly 300. When the heat transfer gas flows through the through-hole, the speed of the heat transfer gas increases sharply due to a sharp decrease in the flow area, thereby increasing the air speed of the heat transfer gas.

The first duct 310 extends along the second direction Y, and the second duct 320 extends along the first direction X. The first duct 310 intersects the second duct 320. A corner region exists at the junction between the first duct 310 and the second duct 320. Eddy flow or reflux of the heat transfer gas is prone to occur at the comer region, thereby reducing the air volume of the heat transfer gas flowing to the first duct 310, and thereby reducing the heat exchange efficiency between the heat transfer gas and the gas in the second box body 210.

In order to improve the heat transfer efficiency between the heat transfer gas and the gas in the second box body 210, in some examples, the air guiding member 330 is disposed at least at the junction between the first duct 310 and the second duct 320. The air guiding member 330 can guide, at the junction, the heat transfer gas to flow to the first duct 310, and reduce the risk of eddy flow and reflux to some extent, thereby improving the heat transfer efficiency between the heat transfer gas and the gas in the second box body 210. As an example, the air guiding member 330 may include an air deflector plate in addition to the through-hole or fan structure. The air deflector plate can effectively deflect the heat transfer gas at the junction, and can significantly reduce the risk of eddy flow and reflux.

Optionally, the air guiding member 330 includes a first guide piece 331 and a second guide piece 332. The first guide piece 331 is disposed at the junction between the first duct 310 and the second duct 320 to drive the heat transfer gas to flow from the second duct 320 toward the first duct 310. The second guide piece 332 is disposed in the first duct 310 to drive the heat transfer gas to flow in the first duct 310 along the second direction Y. The synergistic effect of the first guide piece 331 and the second guide piece 332 can significantly increase the air speed and air volume of the heat transfer gas flowing into the second duct 320, thereby improving the heat transfer efficiency between the heat transfer gas and the gas in the second box body 210, taking away the heat in the second box 210 in time, and improving the overall safety performance of the energy storage device 1000. As an example, both the first guide piece 331 and the second guide piece 332 may be fans. At least one of the first guide piece 331 or the second guide piece 332 further includes a driving mechanism. The driving mechanism is configured to drive the fans to rotate to divert the heat transfer gas. Especially, when the second guide piece 332 includes a driving mechanism, the driving mechanism can increase the flow speed of the heat transfer gas in the first duct 310 significantly. Alternatively, the driving mechanism may be omitted in the first guide piece 331 and the second guide piece 332, and, as driven by the heat transfer gas itself, the fans rotate to divert the heat transfer gas.

Still referring to FIG. 3 and FIG. 4, in some embodiments, the second chamber 112 includes a plurality of air outlets 1121 communicating with the thermal management assembly 120. The second duct 320 includes a plurality of second flow channels 321 communicating with the plurality of air outlets 1121 respectively. Each of the plurality of second flow channels 321 is configured to provide a channel through which the heat transfer gas flows, so as to regulate flow uniformity of the gas. In these embodiments of this application, a plurality of air outlets 1121 are disposed on the second chamber 112, so that the heat transfer gas flows out after being split into a plurality of airflows, thereby improving the flow uniformity of the heat transfer gas. In addition, the air speed at each air outlet 1121 is relatively high, thereby increasing the flow speed of the air flowing into the first duct 310, and in tum, improving the heat transfer efficiency between the heat transfer gas and the gas in the second box body 210. The number of air outlets 1121 may be set to two, three, four, and so on. The number of air outlets 1121 may be flexibly adjusted based on the process requirements, and is not limited herein.

Alternatively, in some other embodiments, the second chamber 112 may include one air outlet 1121 communicating with the thermal management assembly 120. The one air outlet 1121 simplifies the structure of the energy storage device 1000, reduces the overall weight of the energy storage device 1000, and increases the energy density of the energy storage device 1000.

In each of the above embodiments, the battery box 100 and the electrical box 200 may be disposed separately and independently, and the battery box 100 and the electrical box 200 may be transported separately and independently during transportation. Optionally, container corner fittings 500 may be disposed on both the first box body 110 of the battery box 100 and the second box body 210 of the electrical box 200. The container corner fittings 500 can carry the weight of the first box body 110 and the second box body 210, and, during transportation, can be latched to the transportation equipment, thereby reducing the risk of damage to the energy storage device 1000.

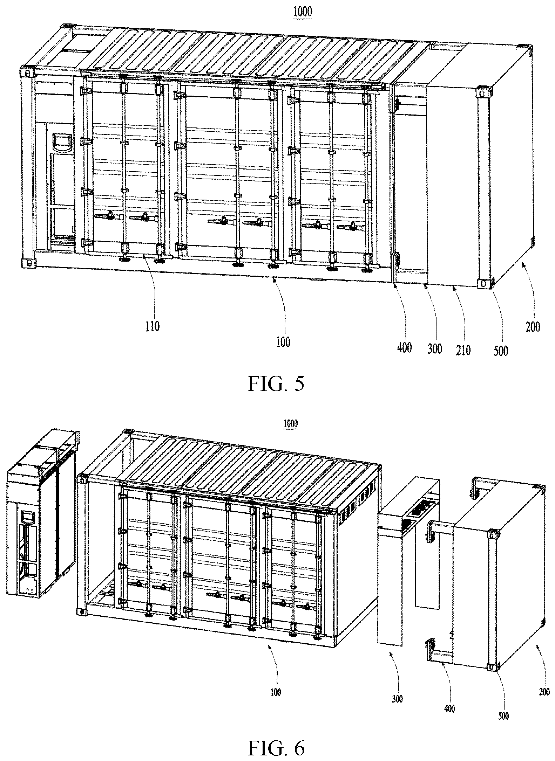

FIG. 5 is a schematic structural diagram of an energy storage device according to some other embodiments of this application, and FIG. 6 is a schematic exploded view of an energy storage device according to some other embodiments of this application.

As shown in FIG. 5 and FIG. 6, in some embodiments, the energy storage device 1000 further includes a fixing piece 400. The fixing piece 400 is fixedly connected to the first box body 110 and the second box body 210 and is configured to clamp at least a part of the air duct assembly 300 between the first box body 110 and the second box body 210. The fixing piece 400 fixedly connects the first box body 110 and the second box body 210 together, thereby improving the structural stability of the energy storage device 1000.

Optionally, container comer fittings 500 may be disposed on both the first box body 110 of the battery box 100 and the second box body 210 of the electrical box 200. The container corner fittings 500 facilitate lifting, handling, and fixing the battery box 100 and the electrical box 200.

In some embodiments, the energy storage device 1000 further includes a battery management system. The battery management system may be disposed in the first box body 110 and electrically connected to the battery cells to control the temperature of the battery cells.

In some embodiments, the energy storage device 1000 further includes a firefighting assembly. The firefighting assembly may be disposed in the second box body 210 and configured to monitor the parameters such as temperature and/or pressure of the battery box 100 and/or electrical box 200. If any one of the parameter values of the temperature and/or pressure exceeds a threshold, the firefighting assembly will control the battery box 100 and/or the electrical box 200.

Although this application has been described with reference to exemplary embodiments, various improvements may be made to the embodiments of this application, and the components of this application may be replaced with equivalents. Particularly, to the extent that no structural conflict exists, various technical features mentioned in various embodiments may be combined in any manner. This application is not limited to the specific embodiments disclosed herein. The scope of protection is defined by the appended claims.

## Claims

1. An energy storage device (1000), comprising:
a battery box (100), comprising a first box body (110), a plurality of battery cells (131), and a thermal management assembly (120), wherein the plurality of battery cells (131) and the thermal management assembly (120) are accommodated in the first box body (110), and the thermal management assembly (120) is configured to provide a heat transfer gas;
an electrical box (200), arranged alongside the battery box (100), wherein the electrical box (200) comprises a second box body (210) and an electrical assembly (211) disposed in the second box body (210), and the electrical assembly (211) is electrically connected to the battery cells (131) to exercise electrical control on the battery box (100); and
an air duct assembly (300), wherein at least a part of the air duct assembly (300) is located between the first box body (110) and the second box body (210) to separate the first box body (110) from the second box body (210), the air duct assembly (300) serves as an air partition to separate the first box body (110) from the second box body (210), and the air duct assembly (300) is in communication with the first box body (110) and the second box body (210) respectively so that the heat transfer gas provided by the thermal management assembly (120) exchanges heat with the electrical box (200) through the air duct assembly (300).

2. The energy storage device (1000) according to claim 1, wherein
the first box body (110) comprises a first chamber (111) and a second chamber (112) arranged side by side along a first direction (X), the first chamber (111) is configured to accommodate the plurality of battery cells (131), and the second chamber (112) is configured to accommodate the thermal management assembly (120);
the second box body (210) is located on a side of the first chamber (111), the side being oriented back from the second chamber (112); and
the air duct assembly (300) comprises a first duct (310) and a second duct (320), the first duct (310) is located between the first chamber (111) and the second box body (210) to separate the first box body (110) from the second box body (210), and the second duct (320) is disposed in the first box body (110) and communicates the first duct (310) and the second chamber (112).

3. The energy storage device (1000) according to claim 2, wherein
the first duct (310) comprises an opening (311) oriented toward a second direction (Y) so that the heat transfer gas flows to an external environment through the opening (311) along the second direction (Y), and the second direction (Y) is parallel to an extension direction of the first duct (310) and perpendicular to the first direction (X).

4. The energy storage device (1000) according to claim 2 or 3, wherein
the first duct (310), a wall (1111) of the first chamber (111), and the second box body (210) close in to form a first flow channel (312), and the first flow channel (312) is configured to provide a channel through which the heat transfer gas flows.

5. The energy storage device (1000) according to any one of claims 2 to 4, wherein the first duct (310) comprises:
a plurality of supporting pieces (313) extending along a second direction (Y), wherein the plurality of the supporting pieces (313) are spaced apart along a third direction (Z) and form an opening (311) between the plurality of supporting pieces (313), and the opening (311) is oriented toward the second direction (Y); and the third direction (Z), the second direction (Y), and the first direction (X) are perpendicular to each other; and
a connecting piece (314) extending along the third direction (Z), wherein the connecting piece (314) is configured to guide an airflow in the second duct (320) to the opening (311).

6. The energy storage device (1000) according to any one of claims 2 to 5, wherein
the air duct assembly (300) comprises an air guiding member (330), wherein the air guiding member (330) is configured to drive the heat transfer gas to flow from the second duct (320) toward the first duct (310).

7. The energy storage device (1000) according to claim 6, wherein
the first duct (310) intersects the second duct (320); and
the air guiding member (330) is disposed at least at a junction between the first duct (310) and the second duct (320).

8. The energy storage device (1000) according to claim 7, wherein
the air guiding member (330) comprises:
a first guide piece (331), disposed at the junction between the first duct (310) and the second duct (320) to drive the heat transfer gas to flow from the second duct (320) toward the first duct (310); and
a second guide piece (332), disposed inside the first duct (310) to drive the heat transfer gas to flow in the first duct (310) along a second direction (Y), and the second direction (Y) is parallel to an extension direction of the first duct (310) and perpendicular to the first direction (X).

9. The energy storage device (1000) according to any one of claims 2 to 8, wherein
the second chamber (112) comprises a plurality of air outlets (1121) in communication with the thermal management assembly (120); and
the second duct (320) comprises a plurality of second flow channels (321) communicating with the plurality of air outlets (1121) respectively, each of the plurality of second flow channels (321) is configured to provide a channel through which the heat transfer gas flows, so as to regulate flow uniformity of the heat transfer gas.

10. The energy storage device (1000) according to any one of claims 1 to 9, wherein
the energy storage device (1000) further comprises a fixing piece (400), and the fixing piece (400) is fixedly connected to the first box body (110) and the second box body (210) and is configured to clamp at least a part of the air duct assembly (300) between the first box body (110) and the second box body (210).

11. The energy storage device (1000) according to any one of claims 1 to 9, wherein container corner fittings (500) are disposed on both the first box body (110) and the second box body (210).

## Patentansprüche

1. Energiespeichervorrichtung (1000), die Folgendes umfasst:
einen Batteriekasten (100), der einen ersten Kastenkörper (110), mehrere Batteriezellen (131) und eine Wärmemanagementbaugruppe (120) umfasst, wobei die mehreren Batteriezellen (131) und die Wärmemanagementbaugruppe (120) in dem ersten Kastenkörper (110) untergebracht sind und die Wärmemanagementbaugruppe (120) dazu ausgelegt ist, ein Wärmeübertragungsgas bereitzustellen;
einen Elektrokasten (200), der entlang des Batteriekastens (100) angeordnet ist, wobei der Elektrokasten (200) einen zweiten Kastenkörper (210) und eine Elektrobaugruppe (211), die in dem zweiten Kastenkörper (210) angeordnet ist, umfasst und wobei die Elektrobaugruppe (211) elektrisch mit den Batteriezellen (131) verbunden ist, um an dem Batteriekasten (100) eine elektrische Steuerung auszuüben; und
eine Luftkanalbaugruppe (300), wobei sich mindestens ein Teil der Luftkanalbaugruppe (300) zwischen dem ersten Kastenkörper (110) und dem zweiten Kastenkörper (210) befindet, um den ersten Kastenkörper (110) von dem zweiten Kastenkörper (210) zu trennen, wobei die Luftkanalbaugruppe (300) als Lufttrennwand dient, um den ersten Kastenkörper (110) von dem zweiten Kastenkörper (210) zu trennen, und wobei die Luftkanalanordnung (300) mit dem ersten Kastenkörper (110) bzw. mit dem zweiten Kastenkörper (210) in Verbindung steht, so dass das durch die Wärmemanagementanordnung (120) bereitgestellte Wärmeübertragungsgas durch die Luftkanalanordnung (300) Wärme mit dem Elektrokasten (200) austauscht.

2. Energiespeichervorrichtung (1000) nach Anspruch 1, wobei
der erste Kastenkörper (110) eine erste Kammer (111) und eine zweite Kammer (112) umfasst, die entlang einer ersten Richtung (X) nebeneinander angeordnet sind, wobei die erste Kammer (111) dazu ausgelegt ist, die mehreren Batteriezellen (131) aufzunehmen, und die zweite Kammer (112) dazu ausgelegt ist, die Wärmemanagementbaugruppe (120) aufzunehmen;
sich der zweite Kastenkörper (210) auf einer Seite der ersten Kammer (111) befindet, wobei die Seite gegenüber der zweiten Kammer (112) auf die Rückseite ausgerichtet ist; und
die Luftkanalanordnung (300) einen ersten Kanal (310) und einen zweiten Kanal (320) umfasst, wobei sich der erste Kanal (310) zwischen der ersten Kammer (111) und dem zweiten Kastenkörper (210) befindet, um den ersten Kastenkörper (110) von dem zweiten Kastenkörper (210) zu trennen, und der zweite Kanal (320) in dem ersten Kastenkörper (110) angeordnet ist und den ersten Kanal (310) und die zweite Kammer (112) verbindet.

3. Energiespeichervorrichtung (1000) nach Anspruch 2, wobei
der erste Kanal (310) eine Öffnung (311) umfasst, die auf eine zweite Richtung (Y) ausgerichtet ist, so dass das Wärmeübertragungsgas durch die Öffnung (311) entlang der zweiten Richtung (Y) zu einer Außenumgebung strömt, und die zweite Richtung (Y) parallel zu einer Verlaufsrichtung des ersten Kanals (310) und senkrecht zu der ersten Richtung (X) ist.

4. Energiespeichervorrichtung (1000) nach Anspruch 2 oder 3, wobei sich der erste Kanal (310), eine Wand (1111) der ersten Kammer (111) und der zweite Kastenkörper (210) schließen, um einen ersten Strömungskanal (312) zu bilden, und der erste Strömungskanal (312) dazu ausgelegt ist, einen Kanal bereitzustellen, durch den das Wärmeübertragungsgas strömt.

5. Energiespeichervorrichtung (1000) nach einem der Ansprüche 2 bis 4, wobei der erste Kanal (310) Folgendes umfasst:
mehrere Stützstücke (313), die entlang einer zweiten Richtung (Y) verlaufen, wobei die mehreren Stützstücke (313) entlang einer dritten Richtung (Z) beabstandet sind und zwischen den mehreren Stützstücken (313) eine Öffnung (311) bilden und die Öffnung (311) auf die zweite Richtung (Y) ausgerichtet ist; wobei die dritte Richtung (Z), die zweite Richtung (Y) und die erste Richtung (X) senkrecht zueinander sind; und
ein Verbindungsstück (314), das entlang der dritten Richtung (Z) verläuft, wobei das Verbindungsstück (314) dazu ausgelegt ist, einen Luftstrom in dem zweiten Kanal (320) zu der Öffnung (311) zu leiten.

6. Energiespeichervorrichtung (1000) nach einem der Ansprüche 2-5, wobei die Luftkanalanordnung (300) ein Luftleitelement (330) umfasst, wobei das Luftleitelement (330) dazu ausgelegt ist, das Wärmeübertragungsgas anzutreiben, um von dem zweiten Kanal (320) in Richtung des ersten Kanals (310) zu strömen.

7. Energiespeichervorrichtung (1000) nach Anspruch 6, wobei
der erste Kanal (310) den zweiten Kanal (320) schneidet; und
das Luftleitelement (330) mindestens an einer Verbindungsstelle zwischen dem ersten Kanal (310) und dem zweiten Kanal (320) angeordnet ist.

8. Energiespeichervorrichtung (1000) nach Anspruch 7, wobei
das Luftleitelement (330) Folgendes umfasst:
ein erstes Führungsstück (331), das an der Verbindungsstelle zwischen dem ersten Kanal (310) und dem zweiten Kanal (320) angeordnet ist, um das Wärmeübertragungsgas anzutreiben, um von dem zweiten Kanal (320) in Richtung des ersten Kanals (310) zu strömen; und
ein zweites Führungsstück (332), das innerhalb des ersten Kanals (310) angeordnet ist, um das Wärmeübertragungsgas anzutreiben, um entlang einer zweiten Richtung (Y) in dem ersten Kanal (310) zu strömen, wobei die zweite Richtung (Y) parallel zu einer Verlaufsrichtung des ersten Kanals (310) und senkrecht zu der ersten Richtung (X) ist.

9. Energiespeichervorrichtung (1000) nach einem der Ansprüche 2 bis 8, wobei
die zweite Kammer (112) mehrere Luftauslässe (1121) in Verbindung mit der Wärmemanagementbaugruppe (120) umfasst; und
der zweite Kanal (320) mehrere zweite Strömungskanäle (321) umfasst, die jeweils mit den mehreren Luftauslässen (1121) in Verbindung stehen, wobei jeder der mehreren zweiten Strömungskanäle (321) dazu ausgelegt ist, einen Kanal bereitzustellen, durch den das Wärmeübertragungsgas strömt, um eine Strömungsgleichmäßigkeit des Wärmeübertragungsgases zu regulieren.

10. Energiespeichervorrichtung (1000) nach einem der Ansprüche 1 bis 9, wobei die Energiespeichervorrichtung (1000) ferner ein Fixierstück (400) umfasst, wobei das Fixierstück (400) fest mit dem ersten Kastenkörper (110) und mit dem zweiten Kastenkörper (210) verbunden ist und dazu ausgelegt ist, mindestens einen Teil der Luftkanalanordnung (300) zwischen dem ersten Kastenkörper (110) und dem zweiten Kastenkörper (210) festzuklemmen.

11. Energiespeichervorrichtung (1000) nach einem der Ansprüche 1 bis 9, wobei sowohl am ersten Kastenkörper (110) als auch am zweiten Kastenkörper (210) Behältereckbeschläge (500) angeordnet sind.

## Revendications

1. Dispositif (1000) de stockage d'énergie, comprenant :
un caisson (100) de batterie, comprenant un premier corps (110) de caisson, une pluralité d'éléments (131) de batterie et un ensemble (120) de gestion thermique, la pluralité d'éléments (131) de batterie et l'ensemble (120) de gestion thermique étant logés dans le premier corps (110) de caisson, et l'ensemble (120) de gestion thermique étant configuré pour fournir un gaz de transfert de chaleur ;
un caisson électrique (200), disposé le long du caisson (100) de batterie, le caisson électrique (200) comprenant un deuxième corps (210) de caisson et un ensemble électrique (211) disposé dans le deuxième corps (210) de caisson, et l'ensemble électrique (211) étant connecté électriquement aux éléments (131) de batterie pour exercer une commande électrique sur le caisson (100) de batterie ; et
un ensemble (300) de conduits d'air, au moins une partie de l'ensemble (300) de conduits d'air étant située entre le premier corps (110) de caisson et le deuxième corps (210) de caisson pour séparer le premier corps (110) de caisson du deuxième corps (210) de caisson, l'ensemble (300) de conduits d'air servant de cloison d'air pour séparer le premier corps (110) de caisson du deuxième corps (210) de caisson, et l'ensemble (300) de conduits d'air étant en communication respectivement avec le premier corps (110) de caisson et le deuxième corps (210) de caisson de sorte que le gaz de transfert de chaleur fourni par l'ensemble (120) de gestion thermique échange de la chaleur avec le caisson électrique (200) au travers de l'ensemble (300) de conduits d'air.

2. Dispositif (1000) de stockage d'énergie selon la revendication 1,
le premier corps (110) de caisson comprenant une première chambre (111) et une deuxième chambre (112) disposées côte à côte suivant une première direction (X), la première chambre (111) étant configurée pour recevoir la pluralité d'éléments (131) de batterie, et la deuxième chambre (112) étant configurée pour recevoir l'ensemble (120) de gestion thermique ;
le deuxième corps (210) de caisson étant situé sur un côté de la première chambre (111), le côté étant orienté vers l'arrière par rapport à la deuxième chambre (112) ; et
l'ensemble (300) de conduits d'air comprenant un premier conduit (310) et un deuxième conduit (320), le premier conduit (310) étant situé entre la première chambre (111) et le deuxième corps (210) de caisson pour séparer le premier corps (110) de caisson du deuxième corps (210) de caisson, et le deuxième conduit (320) étant disposé dans le premier corps (110) de caisson et faisant communiquer le premier conduit (310) et la deuxième chambre (112).

3. Dispositif (1000) de stockage d'énergie selon la revendication 2,
le premier conduit (310) comprenant une ouverture (311) orientée vers une deuxième direction (Y) de sorte que le gaz de transfert de chaleur s'écoule vers un environnement externe à travers l'ouverture (311) suivant la deuxième direction (Y) et la deuxième direction (Y) étant parallèle à une direction d'extension du premier conduit (310) et perpendiculaire à la première direction (X).

4. Dispositif (1000) de stockage d'énergie selon la revendication 2 ou 3,
le premier conduit (310), une paroi (1111) de la première chambre (111) et le deuxième corps (210) de caisson se refermant pour former un premier canal (312) d'écoulement, et le premier canal (312) d'écoulement étant configuré pour constituer un canal à travers lequel s'écoule le gaz de transfert de chaleur.

5. Dispositif (1000) de stockage d'énergie selon l'une quelconque des revendications 2 à 4, le premier conduit (310) comprenant :
une pluralité de pièces (313) de soutien s'étendant suivant une deuxième direction (Y), la pluralité de pièces (313) de soutien étant espacée suivant une troisième direction (Z) et formant une ouverture (311) entre la pluralité de pièces (313) de soutien, et l'ouverture (311) étant orientée vers la deuxième direction (Y) ; et la troisième direction (Z), la deuxième direction (Y) et la première direction (X) étant perpendiculaires entre elles ; et
une pièce (314) de liaison s'étendant suivant la troisième direction (Z), la pièce (314) de liaison étant configurée pour guider un flux d'air dans le deuxième conduit (320) jusqu'à l'ouverture (311).

6. Dispositif (1000) de stockage d'énergie selon l'une quelconque des revendications 2 à 5, l'ensemble (300) de conduits d'air comprenant un organe (330) de guidage d'air, l'organe (330) de guidage d'air étant configuré pour entraîner le gaz de transfert de chaleur à s'écouler du deuxième conduit (320) vers le premier conduit (310).

7. Dispositif (1000) de stockage d'énergie selon la revendication 6,
le premier conduit (310) croisant le deuxième conduit (320) ; et
l'organe (330) de guidage d'air étant disposé au moins au niveau d'une jonction entre le premier conduit (310) et le deuxième conduit (320).

8. Dispositif (1000) de stockage d'énergie selon la revendication 7,
l'organe (330) de guidage d'air comportant :
une première pièce (331) de guidage, disposée à la jonction entre le premier conduit (310) et le deuxième conduit (320) pour amener le gaz de transfert de chaleur à s'écouler du deuxième conduit (320) vers le premier conduit (310) ; et
une deuxième pièce (332) de guidage, disposée à l'intérieur du premier conduit (310) pour amener le gaz de transfert de chaleur à s'écouler dans le premier conduit (310) suivant une deuxième direction (Y), et la deuxième direction (Y) étant parallèle à une direction d'extension du premier conduit (310) et perpendiculaire à la première direction (X).

9. Dispositif (1000) de stockage d'énergie selon l'une quelconque des revendications 2 à 8,
la deuxième chambre (112) comprenant une pluralité de sorties (1121) d'air en communication avec l'ensemble (120) de gestion thermique ; et
le deuxième conduit (320) comprenant une pluralité de deuxièmes canaux (321) d'écoulement communiquant respectivement avec la pluralité de sorties (1121) d'air, chacun de la pluralité de deuxièmes canaux (321) d'écoulement étant configuré pour constituer un canal dans lequel s'écoule le gaz de transfert de chaleur, de manière à réguler l'uniformité d'écoulement du gaz de transfert de chaleur.

10. Dispositif (1000) de stockage d'énergie selon l'une quelconque des revendications 1 à 9, le dispositif (1000) de stockage d'énergie comprenant en outre une pièce (400) de fixation, la pièce (400) de fixation étant reliée de manière fixe au premier corps (110) de caisson et au deuxième corps (210) de caisson et étant configurée pour serrer au moins une partie de l'ensemble (300) de conduits d'air entre le premier corps (110) de caisson et le deuxième corps (210) de caisson.

11. Dispositif (1000) de stockage d'énergie selon l'une quelconque des revendications 1 à 9, des ferrures (500) de coin de conteneur étant disposées à la fois sur le premier corps (110) de caisson et sur le deuxième corps (210) de caisson.
